# EUROPEAN PATENT APPLICATION

(11) **EP 0 797 307 A2**
(43) Date of publication of application: **24.09.1997**
(21) Application number: 97101923.7
(22) Date of filing: 06.02.1997
(51) Int. Cl.: H03M 13/12

(54) **Depuncturing circuit**

(30) Priority: 22.03.1996 JP 91812/96
(71) Applicant: KABUSHIKI KAISHA KENWOOD, Shibuya-ku Tokyo (JP)
(72) Inventor: Tsurumi, Atsushi, Kawasaki-shi, Kanagawa (JP)
(74) Representative: Patentanwälte Leinweber & Zimmermann

(57) **Abstract**

A depuncturing circuit is provided which can process a convolutional code changing its code rate in unit of block. A punctured convolutional code changing its code rate in unit of block is written in a memory circuit 11.
A puncturing enable signal j is repetitively generated by a puncturing enable creating circuit until the block number counted by a counter 13 with reference to an index h reaches the block number stored in the puncturing enable creating circuit 15. The puncturing enable signal j is supplied to a read address generator 16 and a selection circuit 17. The read address generator 16 increments a read address when the puncturing enable signal j takes a high potential to read data l stored in the memory circuit 11. The selection circuit 17 selects the data l while the puncturing enable signal j takes the high potential and selects dummy data m while it takes a low potential, to thus depuncture the convolutional code.
The depunctured data is parallel converted and output.

## Description

### BACKGROUND OF THE INVENTION

### 1. Field of the Invention

The present invention relates to a depuncturing circuit which is a pre-process circuit for decoding a convolutional code subjected to a puncturing procedure, and more particularly to a depuncturing circuit applicable to a digital audio broadcasting system (hereinafter called DAB where appropriate) conforming with European Specifications, and the like.

### 2. Related Background Art

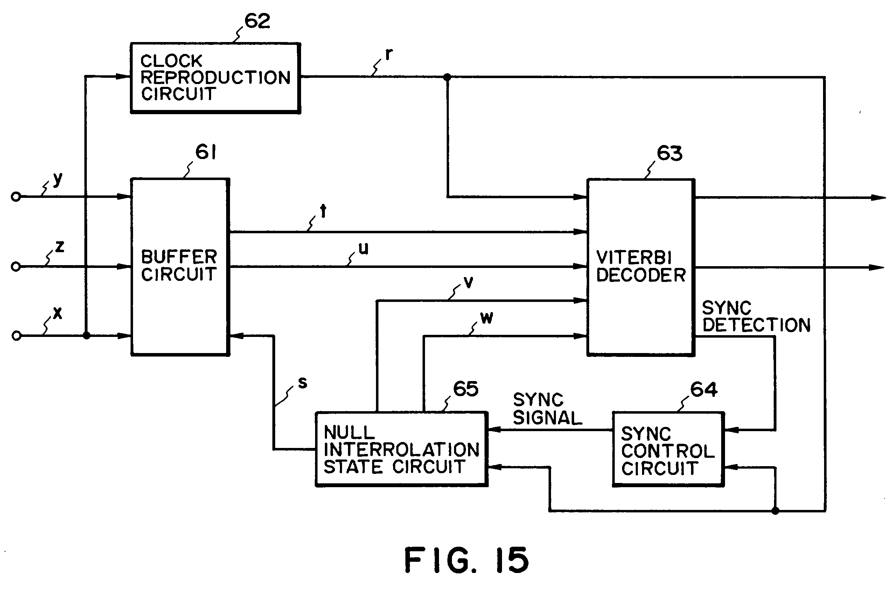

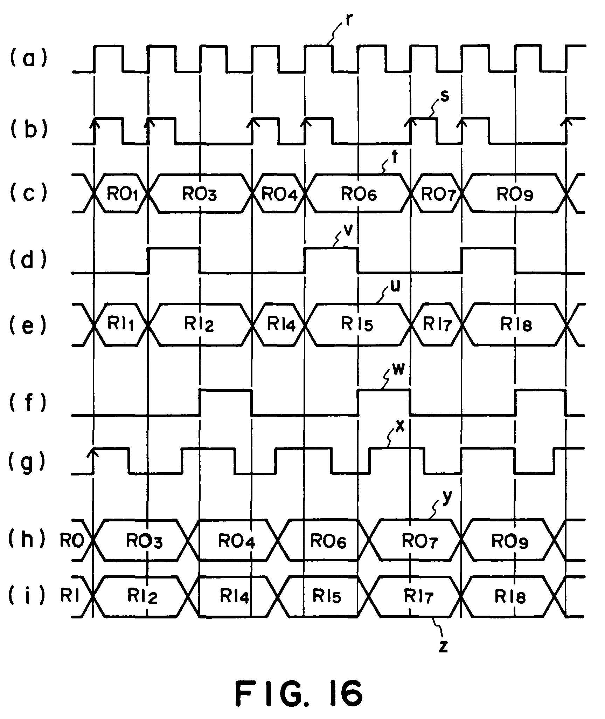

A depuncturing circuit of this kind has been structured such as shown in Fig. 15. Fig. 16 is a timing chart illustrating the operation of the conventional depuncturing circuit shown in Fig. 15. The depuncturing circuit shown in Fig. 15 depunctures a convolutional code puncture-encoded at a code rate of 3/4.
Punctured convolutional input codes y and z are written into a buffer circuit 61 in response to a clock signal x synchronizing with the input codes. A clock reproduction circuit 62 reproduces a clock signal r from the clock signal x. The clock signal r is input to a viterbi decoder 63 and to a sync control circuit 64.

The sync control circuit 64 generates a sync signal from a sync detection output supplied from the viterbi decoder 63 and the clock signal r, the sync signal controlling a null interpolation state circuit 65. This null interpolation state circuit 65 generates a read clock signal s for reading data y and z from the buffer circuit 61 and generates erase signals v and w. Data t and u read from the buffer circuit 61 in response to the read clock signal s and the erase signals v and w are input to the viterbi decoder 63 which performs viterbi decoding.
This conventional depuncturing circuit is effective for data punctured at a fixed code rate. The clock reproduction circuit 62 is not necessary if a master clock signal is prepared which is the least common denominator of the clock signal x input to the buffer circuit 61 and the clock signal r input to the viterbi decoder 63.
This conventional depuncturing circuit is associated, however, with some drawbacks if it is applied to convolutional codes of the DAB Specifications. According to the DAB format, a convolutional code is a burst signal complete in unit of frame, and this burst signal is divided into blocks which are further divided into sub-blocks. Twenty five sets of code rates (puncturing vectors) are prepared for sub-blocks as shown in Figs. 11 and 12. The puncturing vector changes with the position of each block. For a signal such as audio service information, this change has sixty four combinations depending upon bit rates and protection levels (error correction ability) as shown in Figs. 13 and 14.
Therefore, code rates change with time and there are a number of code rate combinations. If the convolution code punctured in conformity with the DAB format is to be processed by the conventional circuit shown in Fig. 15, the least common denominator of the clock signal x input to the buffer circuit and the clock signal r input to the viterbi decoder is a very high frequency because there are twenty five sets of code rates. Therefore, this circuit cannot be realized by CMOS devices.
It is very difficult, therefore, to use only one master clock for frequency division. The clock reproduction circuit is required to be formed by, for example, a plurality of PLL circuits. In this case, not only the circuit becomes expensive essentially, but also unnecessary radiative noises may be generated by mutual interference of a number of asynchronous clock signals.
Read/write timings also become complicated so that it is impossible to use the conventional null interpolation state circuit shown in Fig. 15 which is formed by a simple circuit constituted by a counter and a combinational circuit.

### SUMMARY OF THE INVENTION

It is an object of the present invention to provide a depuncturing circuit capable of processing convolutional codes whose code rate changes in unit of block, particularly a depuncturing circuit capable of depuncturing codes punctured in conformity with the DAB format.
A depuncturing circuit of this invention comprises: write address generator means for generating a write address; first memory means for storing a convolutional code changing its code rate in unit of block at a write address generated by the write address generator means; a counter for counting the number of blocks; second memory means for storing in advance index information representative of a level of an error correction procedure and a corresponding block number and puncturing pattern information to be used a plurality of times corresponding to the block number; read control means for designating a read address through a selective count operation based on the puncturing pattern information and reading data from the first memory means at the designated read address; selector means for selecting either the data read from the first memory means in accordance with the contents of the puncturing pattern information or dummy data if the data read from the first memory means is not selected; puncturing pattern read means for reading the puncturing pattern information from the second memory means by referring to the index information until the block number counted by the counter reaches the block number stored in the second memory means and sending the read puncturing pattern information to the read control means and the selector means; and serial/parallel converter means for converting a serial output of the selector means and the puncturing pattern information into a parallel output and supplying the parallel output to a convolutional code decoder.
According to the depuncturing circuit of this invention, a convolutional code changing its code rate in unit of block is written in the first memory means at the write address generated by the write address generator means. The number of blocks is counted by the counter. The puncturing pattern read means reads puncturing pattern information from the second memory means until the block number counted by the counter with reference to the index information reaches the block number stored in the second memory means, and the read puncturing pattern information is sent to the read control means and selector means.
Under the control of the read control means supplied with the puncturing pattern information read from the second memory means, a read address is generated through a selective count operation based on the puncturing pattern information, and data is read from the first memory means at the generated read address.
In operation of reading data from the first memory means, the read address is incremented, for example, while the puncturing pattern information takes the high potential, and the read address is not incremented while it takes the low potential. The selector means receiving data read from the first memory means selects either this data in accordance with the contents of the puncturing pattern information, or the dummy data if the data in the first memory means is not selected. If the puncturing pattern information takes, for example, the high potential, the read data is selected, whereas if it takes the low potential, the dummy data is selected. In this manner, the selector means can depuncture the input data. The depunctured data sent from the selector means is converted into parallel data by the serial/parallel converter means.

### BRIEF DESCRIPTION OF THE DRAWINGS

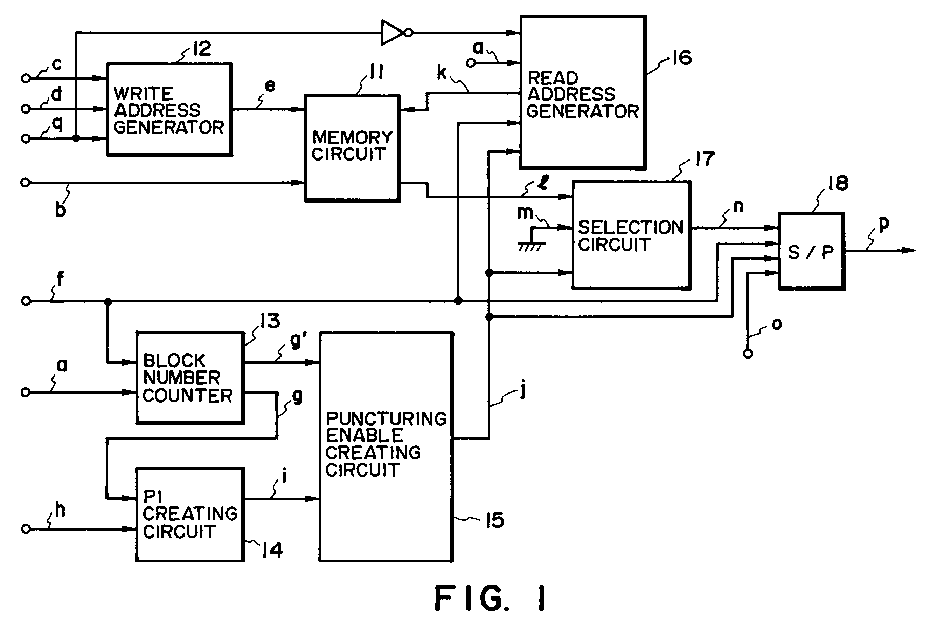

Fig. 1 is a block diagram showing the structure of a depuncturing circuit according to an embodiment of the invention.

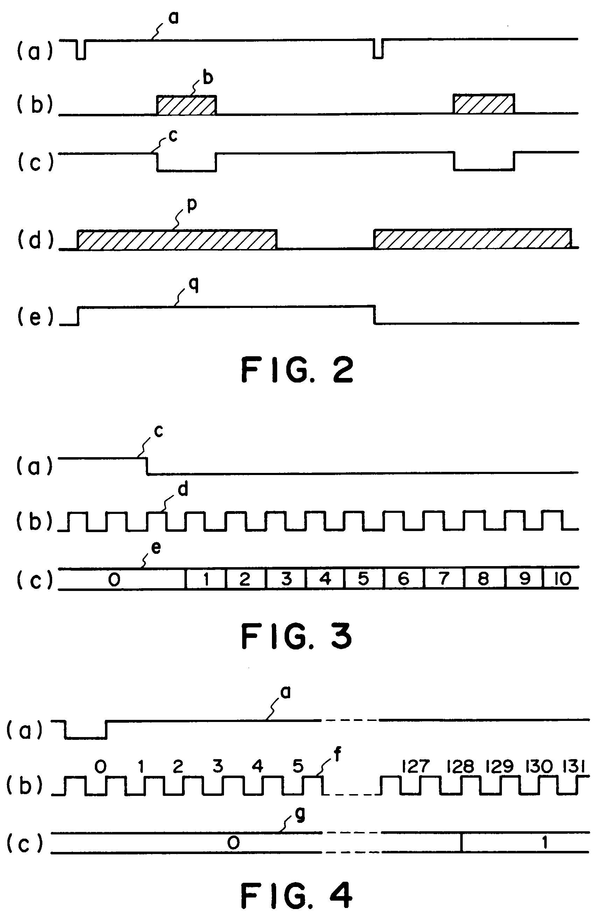

Fig. 2 is a timing chart illustrating the operation of the depuncturing circuit of the embodiment.

Figs. 3 to 7 are timing charts illustrating the operation of the depuncturing circuit of the embodiment.

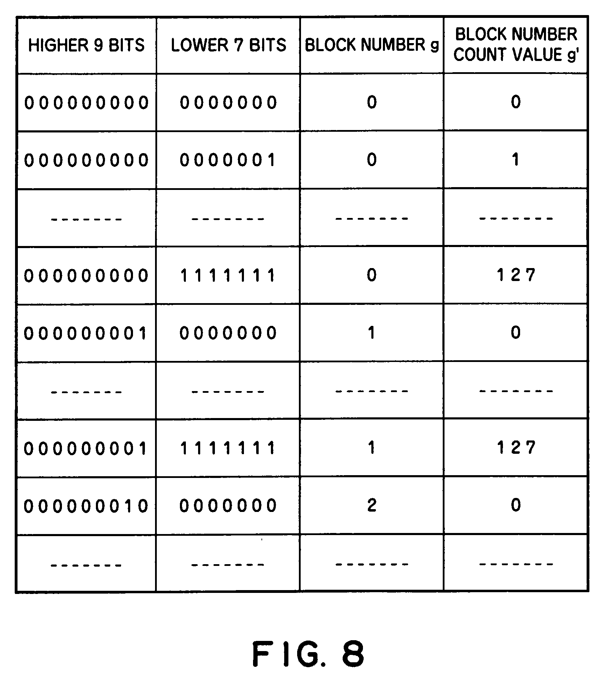

Fig. 8 is a schematic diagram illustrating the operation of a block number counter circuit of the depuncturing circuit of the embodiment.

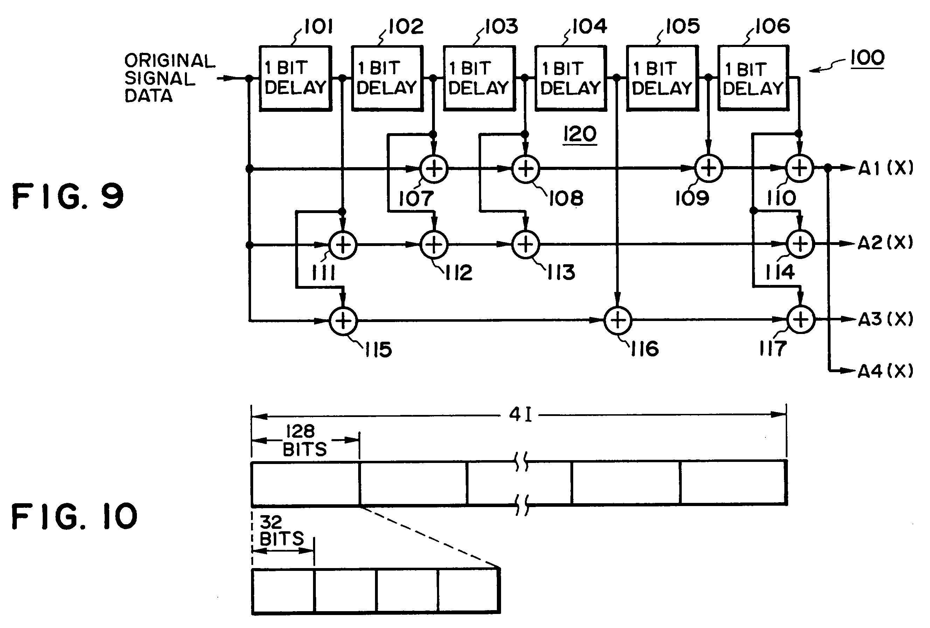

Fig. 9 is a block diagram showing the structure of a convolutional code encoder from which data is input to the depuncturing circuit of the embodiment.

Fig. 10 is a diagram illustrating blocks and sub-blocks of data input to the depuncturing circuit of the embodiment.

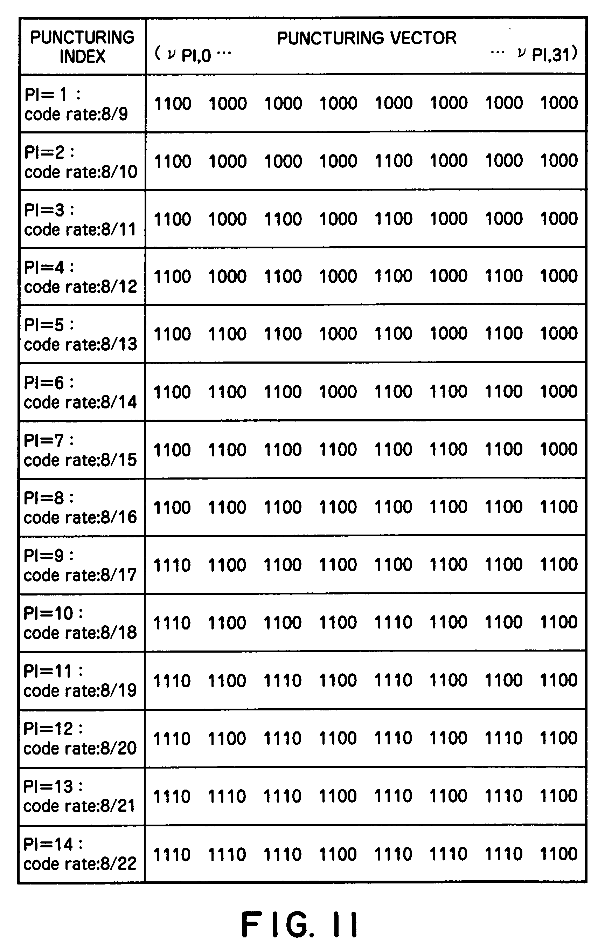

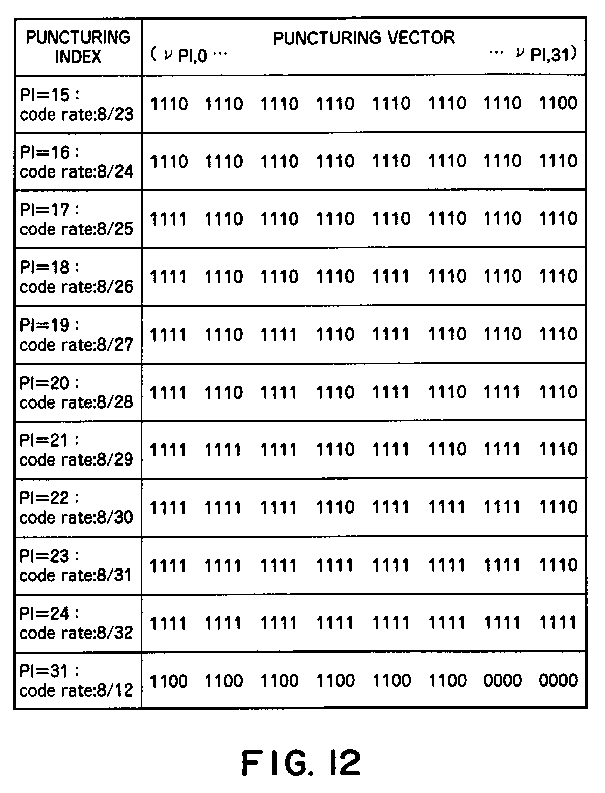

Figs. 11 and 12 are tables stored in a memory of a puncturing enable creating circuit of the depuncturing circuit of the embodiment.

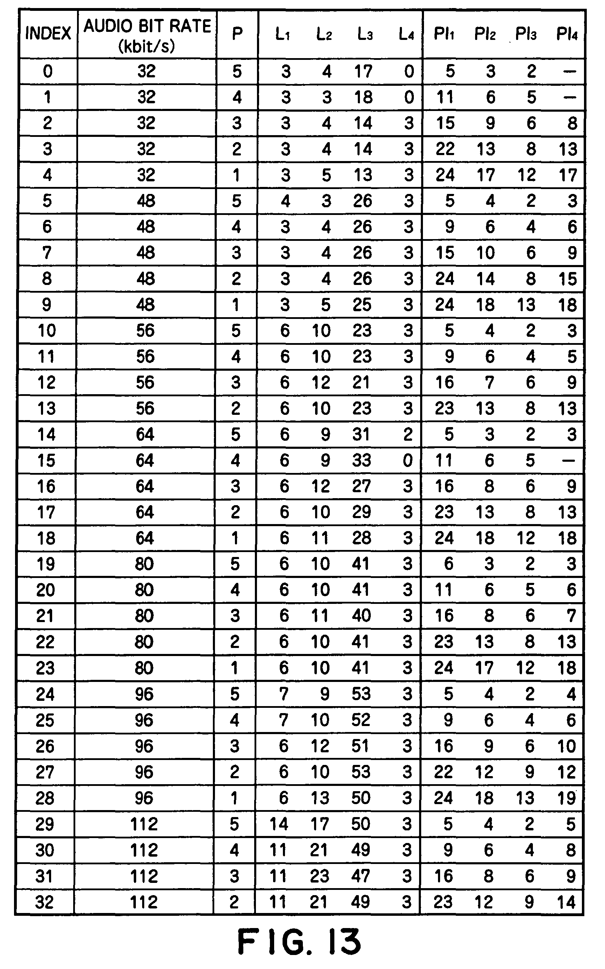

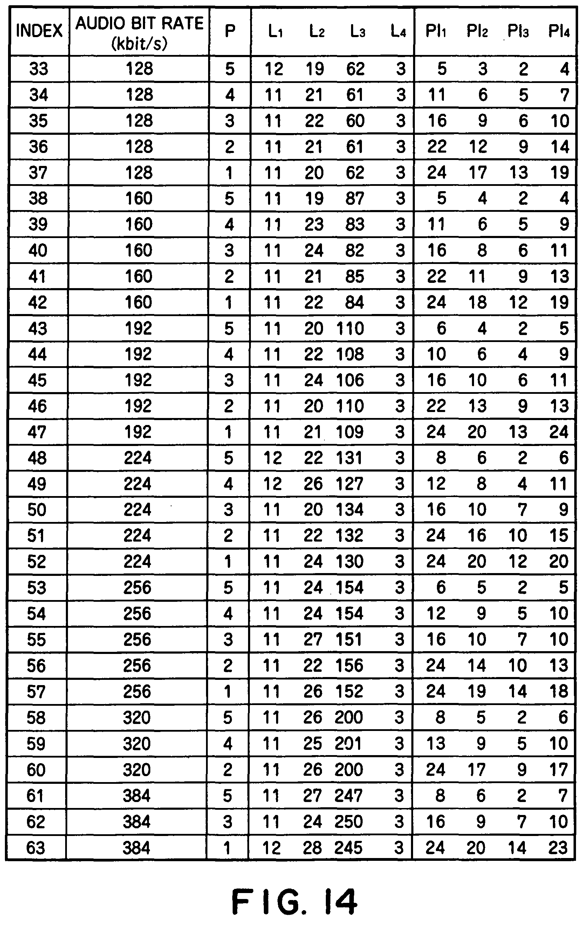

Figs. 13 and 14 are tables stored in a memory of a puncturing index PI creating circuit of the depuncturing circuit of the embodiment.

Fig. 15 is a block diagram showing the structure of a conventional depuncturing circuit.

Fig. 16 is a timing chart illustrating the operation of the conventional depuncturing circuit shown in Fig. 15.

### DETAILED DESCRIPTION OF THE PREFERRED EMBODIMENTS

An embodiment of a depuncturing circuit of this invention will be described. Fig. 1 is a block diagram showing the structure of a depuncturing circuit applied to the DAB system according to an embodiment of the invention. First, encoding of a convolutional code standardized by the European Specifications DAB and the data input to the depuncturing circuit will be described.
An original signal of one frame is assumed to have I bits. One frame bit stream data of I bits is converted in unit of frame into convolutional codes at a constraint length of 7 and a code rate of 1/4. Code data convolutionally encoded at the constraint length of 7 and the code rate of 1/4 is punctured in accordance with a preset rule and input to the depuncturing circuit as a burst signal in unit of frame.

As shown in Fig. 9, a convolutional code encoder 120 is constituted of a shift register 100 made of one bit delays 101 to 106 and modulo-2 adders 107 to 117. Since the code rate is 1/4, 4I bits and 24 (6 x 4) bits of the remaining data in the six delays of the convolutional encoder become convolutional data. Assuming that the initial and final states of the convolutional encoder 120 are all 0s, if the original signal data is encoded by the convolutional encoder 120 (I + 6) times and serially converted, then the output of (4I + 24) bits becomes the convolutional data. The convolutionally encoded data is output in 4-bit parallel and serially converted to form bits of four times the bits (I + 6).
As shown in Fig. 10, the serial data of an output from the convolutional code encoder 120 is divided into blocks of 128 bits for the first 4I bits, and each block is further divided into sub-blocks of 32 bits. A puncturing index PO indicating a puncturing pattern of each block is defined as shown in Figs. 11 to 14 in association with an index IDX 0 to 32. All sub-blocks in each block are punctured by using the same puncturing vector VPI. This will be detailed in the following. The index IDX determines a bit rate and a protection level indicating a level of the error correction procedure.
The puncturing index PI is defined in unit of block of 128 bits and becomes different depending upon the data bit rate and the protection level P indicating an error correction ability (refer to Figs. 13 and 14). In Figs. 13 and 14, a P column is a protection level column, an L₁ to L₄ column is a block number column, and a PI₁ to PI₄ column is a puncturing index column.
In Figs. 13 and 14, P indicates the protection level, L₁ to L₄ indicate the number of blocks, and PI₁ to PI₄ indicate the puncturing index. The top L₁ blocks are punctured using the PI₁ puncturing index, the next L₂ blocks are punctured using the PI₂ puncturing index, the next L₃ blocks are punctured using the PI₃ puncturing index, and the next L₄ blocks are depunctured using the PI₄ puncturing index.
As shown in Figs. 11 and 12, twenty four puncturing indices PI = 1 to PI = 24 are prepared for the puncturing vector VPI which determines at which position data is punctured. For the last 24 bits remaining after the 4I bits, a puncturing vector VT to be described later is used. In Figs. 11 and 12, the left column shows the puncturing index, and the right column shows the puncturing vector in sub-block unit. In Figs. 11 to 14, puncturing vectors are associated with the puncturing index PI and correspond to puncturing pattern information.

The puncturing vector VT is defined as:
VT = (1100 1100 1100 1100 1100 1100)
12 bits obtained through puncturing using these 24 bits are called tail bits. In this embodiment, the puncturing index PI = 31 (at the last row in Fig. 12) corresponds to a vector of 32 bits constituted of the VT vector and the 25th to 32nd bits "0". "0" in each puncturing vector is deleted at the puncturing procedure.
With reference to Fig. 1, the depuncturing circuit of this embodiment will be described. Figs. 2 to 7 are timing charts illustrating the operation of the depuncturing circuit of this embodiment.
Input data b of the convolutional code punctured in unit of block is written in a memory circuit 11 at an address designated by a write address generator 12. The memory circuit 11 has a memory capacity of two frames. The write address generator 12 is made of a counter which is incremented in response to an input data clock d while an input data valid signal c indicating that the input data b is valid takes a low potential, and which outputs the count as lower addresses and a signal g associated with the frame phase as an MSB address to thereby generate a write address e.
The input data valid signal c is a signal of a predetermined length triggered by a signal synchronized with a burst signal input synchronously with a frame sync signal. The signal g associated with the frame phase is a signal inverting its level each time the frame sync signal is supplied, and for example, a signal output from a T-type flip-flop receiving the frame sync signal.
A block number counter 13 is a 16-bit counter which counts a read clock signal f to output lower seven bits (0 to 127) of the count as a block number count g' and to output upper nine bits incremented every 128 counts as a block number g. This counter is reset by the frame sync signal a. The relationship between the block number g and the block number count g' is shown in Fig. 8.
A puncturing index PI creating circuit 14 is made of a memory circuit in which stored in advance are the puncturing correspondence tables shown in Figs. 13 and 14. The puncturing index PI creating circuit 14 generates a puncturing index PI i by referring to the input block number g and index IDX h.
A puncturing enable creating circuit 15 is made of a memory circuit in which stored in advance are the puncturing vector correspondence tables shown in Figs. 11 and 12. The puncturing enable creating circuit 15 generates a puncturing enable signal j by referring to the input puncturing index PI i and count g' from the block number counter 13.

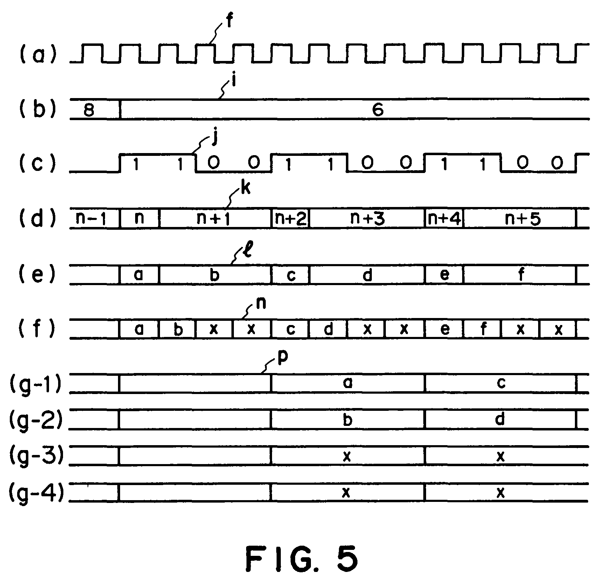

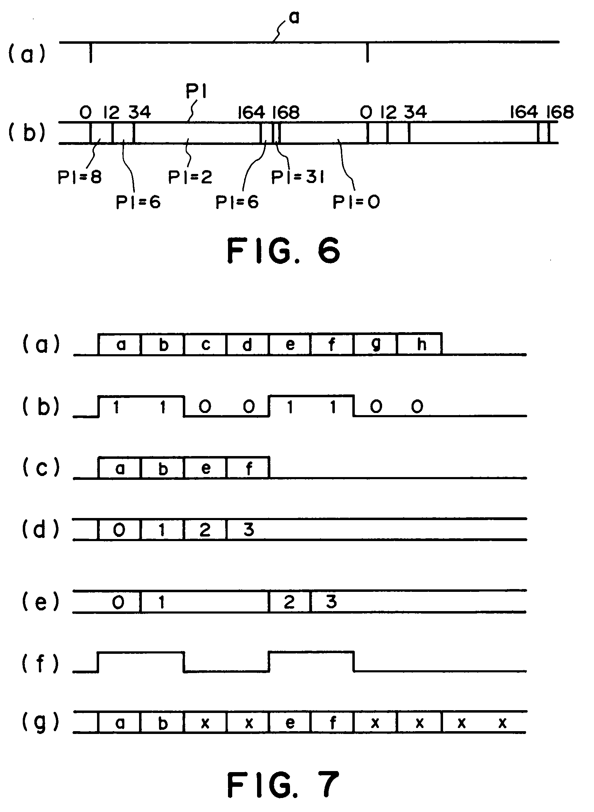

A read address generator 16 is an address counter which is reset by the frame sync signal a and counts the read clock signal f while the puncturing enable signal j takes a high potential, to thus output a read address k for a read control of the memory circuit 11. The MSB of the read address is an inverted signal of the signal g associated with the frame phase and the lower addresses are the count of this address counter.
Data l read from the memory circuit 11 at the read address is supplied to a selection circuit 17 which selects the read data l while the puncturing enable signal j takes a high potential and selects dummy data m while it takes a low potential, to thus output selected data n.
The selected data n and puncturing enable signal j are supplied to a serial/parallel S/P converter circuit 18 synchronously with the read clock signal f and parallel converted synchronously with a viterbi clock signal o, to thus output a viterbi input data and erase signal p.
The operation of the puncturing circuit of this embodiment constructed as above will be described. The input data b punctured is output for each frame after a delay of one frame. Since the memory circuit 11 has a capacity of two frames and the write address MSB and read address MSB have inverted polarities, the read/write operations will not collide with each other.
The input data b is supplied in a burst form as indicated at (b) in Fig. 2 synchronously with the frame sync signal indicated at (a) in Fig. 2. In response to the input data valid signal c synchronizing with the input data b, the write address generator 12 which counts the input data clock d while the input data valid signal c takes the low potential, outputs a write address to the memory circuit 11.
As shown in Fig. 3, in operation of outputting the write address from the write address generator 13, the write address generator 13 is reset while the input data valid signal c indicated at (a) in Fig. 3 takes the high potential, and counts the input data clock signal d indicated at (b) in Fig. 3 while the input data valid signal c takes the low potential. This count is e' indicated at (c) in Fig. 3. In the case of the index IDX of "24" and the protection level P of "5", data of 7420 bits per one frame is written. This data is written in the memory circuit 11 at the write address e having the signal g associated with the frame phase as MSB and the address count e' indicated at (c) in Fig. 3 as the lower address bits.
One block is constituted of 128 bits. The block number counter 13 is reset by the frame sync signal a indicated at (a) in Fig. 4 and counts the read clock signal f indicated at (b) in Fig. 4. Each time the read clock signal f is counted "128" times, the block number counter 13 outputs the block number g indicated at (c) in Fig. 4. Each time the block number changes, the puncturing index PI creating circuit 14 outputs a corresponding puncturing index PI. In the following description, the index IDX is assumed to be "48". The block number g is related to the values L₁ to L₄ shown in Figs. 13 and 14. For the block numbers g of "0" to "11" (because L₁ = "12") the puncturing index PI is "8", for the block numbers g of "12" to "33" (L₁ + L₂ = "34") the puncturing index PI is "6", for the block numbers g of "34" to "164" (L₁ + L₂ + L₃ = "165") the puncturing index PI is "2", for the block numbers g of "165" to "167" (L₁ + L₂ + L₃ + L₄ = "168") the puncturing index PI is "6", for the block number g of "168" the puncturing index PI representative of the tail bits is "31", and for the other block numbers g the puncturing index PI is "0".
The puncturing enable creating circuit 15 stores therein a table of the puncturing indices PI shown in Figs. 11 and 12 and the block number count (indicating the block number). If the value of the puncturing index PI is "6", the block number counter 13 counts the read clock signal f (0, 1, 2, 3, 4,..., 126, 127) and the puncturing vector (1100 1100 1100 1000 1100 1100 1100 1000) is repeated four times per one block. This pattern is output as the puncturing enable signal j. This relationship is schematically shown in Fig. 6. The sync signal a is indicated at (a) in Fig. 6, the puncturing index PI is indicated at (b) in Fig. 6, and the counted block number g "0,..., 168" is indicated at (b) in Fig. 6.
If the puncturing index PI is "31", i.e., if the block is the tail bits, (1100 1100 1100 1100 1100 1100 0000 0000) is output for the first sub-block and (0000 0000 0000 0000 0000 0000 0000 0000) is output for the remaining three sub-blocks, respectively as the puncturing signal j. If the puncturing index PI is "0", all 0s are output.
The read address generator 16 receiving the puncturing enable signal j is reset by the frame sync signal a, and counts the read clock signal f indicated at (a) in Fig. 5 while the puncturing enable signal j indicated at (c) in Fig. 5 takes the high potential, and designates an address k indicated at (d) in Fig. 5 for reading data l indicated at (e) from the memory circuit 11, the address k having the count of the read address generator 16 as the lower addresses and an inverted signal of the signal g associated with the frame phase as MSB. The puncturing index is indicated at (b) in Fig. 5.
The selection circuit 17 receiving the data l read from the memory circuit 11 and the puncturing enable signal j selects the data l while the puncturing enable signal j takes the high potential and selects the dummy data m (= 0) while it takes the low potential. Therefore, the selection circuit 17 outputs the selected data n indicated at (f) in Fig. 5. x indicated at (f) in Fig. 5 shows the dummy data m (= 0). This selected data n and puncturing enable signal j are parallel converted by the serial/parallel converter circuit 18 and output as data indicated at (g-1), (g-2), (g-3), and (g-4) in Fig. 5.
If the puncturing enable signal j has a bit "0", the input convolutional code was punctured and the data at this position was deleted. Therefore, if the puncturing enable signal j has a bit "0", the operation of the read address generator 16 is stopped and the dummy data is inserted at this position. This operation is performed by the read address generator 16 and the selection circuit 17.
The puncturing enable signal j can be used as an erase signal for the viterbi decoder. Therefore, the puncturing enable signal j as well as the selected data is supplied to the serial/parallel converter circuit 18 which serial/parallel converts them and outputs the data and the erase signal synchronizing the data.
A fundamental operation will be described with reference to Fig. 7. It is assumed that the convolutional code is (a, b, c, d, e, f, g, h) indicated at (a) in Fig. 7 and the puncturing vector is (1100 1100) indicated at (b) in Fig. 7. The punctured data becomes (a, b, e, f) indicated at (c) in Fig. 7. This data is used as input data and written in the memory circuit 11 at addresses (0, 1, 2, 3) indicated at (d) in Fig. 7.
The read address is incremented when the puncturing enable signal j takes the high potential, and the data l stored in the memory circuit 11 is read at timings indicated at (e) in Fig. 7. The dummy data m is inserted when the puncturing enable signal j indicated at (f) in Fig. 7 takes the low potential. Therefore, data (a, b, x, x, e, f, x, x) indicated at (g) in Fig. 7 is output to the viterbi decoder. x indicates the dummy data.
As described so far, according to the depuncturing circuit of this invention, the convolutional code changing its code rate in unit of block can be correctly decoded. Furthermore, only clock signal frequency divided from the master clock signal is required, and the clock signal reproduction circuit is not required to generate a clock signal having a new frequency so that PLL circuits are not necessary. Still further, the relationship between clock signals is always represented by an integer so that unnecessary clock signal components are not generated reducing radiative noises.
Even if a new puncturing pattern is required to be added or the current puncturing pattern is required to be modified, only the contents of the memory circuit are changed without changing algorithm so that broad expandability is obtained.

## Claims

1. A depuncturing circuit comprising:
write address generator means for generating a write address;
first memory means for storing a convolutional code changing its code rate in unit of block at a write address generated by said write address generator means;
a counter for counting the number of blocks;
second memory means for storing in advance index information representative of a level of an error correction procedure and a corresponding block number and puncturing pattern information to be used a plurality of times corresponding to the block number;
read control means for designating a read address through a selective count operation based on the puncturing pattern information and reading data from said first memory means at the designated read address;
selector means for selecting either the data read from said first memory means in accordance with the contents of the puncturing pattern information or dummy data if the data read from said first memory means is not selected;
puncturing pattern read means for reading the puncturing pattern information from said second memory means by referring to the index information until the block number counted by said counter reaches the block number stored in said second memory means and sending the read puncturing pattern information to said read control means and said selector means; and
serial/parallel converter means for converting a serial output of said selector means and the puncturing pattern information into a parallel output and supplying the parallel output to a convolutional code decoder.
